(19) Europäisches Patentamt

European Patent Office

Office européen des brevets

(11) EP 0 589 749 B1

(12) **FASCICULE DE BREVET EUROPEEN**

(45) Date de publication et mention de la délivrance du brevet:
**16.10.1996 Bulletin 1996/42**

(51) Int Cl.⁶: **H03M 1/06**

(21) Numéro de dépôt: **93402205.4**

(22) Date de dépôt: **10.09.1993**

(54) **Circuit de codage analogique-numérique à compensation automatique du décalage du zéro**

Analog-digitalkodiererschaltung mit Nullpunktabgleich

Analog-digital encoding circuit with zero-offset compensation

(84) Etats contractants désignés:
**DE FR GB IT NL**

(30) Priorité: **25.09.1992 FR 9211451**

(43) Date de publication de la demande:
**30.03.1994 Bulletin 1994/13**

(73) Titulaire: **THOMSON-CSF**
**75008 Paris (FR)**

(72) Inventeurs:
• **Barroue, Thierry**
**F-92402 Courbevoie Cédex (FR)**

• **Carl, Olivier**
**F-92402 Courbevoie Cédex (FR)**

(74) Mandataire: **Beylot, Jacques et al**
**Thomson-CSF**
**SCPI**
**B.P. 329**
**92402 Courbevoie Cédex (FR)**

(56) Documents cités:
**EP-A- 0 466 329**       **EP-A- 0 483 846**
**FR-A- 2 396 463**       **US-A- 4 907 165**

• **PATENT ABSTRACTS OF JAPAN vol. 13, no. 195 (E-754)(3543) 10 Mai 1989 & JP-A-01 016 024**

## Description

La présente invention concerne la compensation automatique du décalage du zéro d'un convertisseur analogique-numérique utilisé notamment dans une chaîne de réception radar à démodulation numérique.

Dans une chaîne de réception radar classique, il est habituel de ne passer en numérique qu'en sorties du démodulateur fournissant les composantes en phase et en quadrature du signal vidéo. On trouve alors deux convertisseurs analogiques-numériques connectés en parallèle sur les sorties en phase et en quadrature du démodulateur en quadrature. Les convertisseurs analogiques-numériques ainsi que le démodulateur en quadrature réalisé en analogique présentent des imperfections qui leur font engendrer des composantes continues parasites évoluant en fonction des variations de divers paramètres tels que la température, les tensions d'alimentation, la fréquence de la porteuse d'émission. Il est habituel d'éliminer ces composantes continues parasites en les isolant dans le bruit radar par une mesure des moyennes des amplitudes des signaux en sortie des deux convertisseurs analogiques-numériques pendant un silence radar par exemple sur les cases distance les plus éloignées atteintes après chaque émission d'une impulsion d'interrogation pour lesquelles le retour d'un écho significatif est improbable et en retranchant ces moyennes des signaux de sortie des convertisseurs analogiques-numériques.

Un tel système présente au moins deux inconvénients : d'une part celui de nécessiter des circuits numériques spéciaux, de structure complexe, pour effectuer des moyennes sur le bruit du radar en sortie des convertisseurs analogiques-numériques et d'autre part, l'obligation d'avoir un silence radar sur la période de mesure suivant l'émission de chaque impulsion d'interrogation ce qui aiminue le temps opérationnel du radar et peut être impossible à obtenir en présence d'un brouilleur.

Avec les progrès en fréquence des convertisseurs analogiques-numériques, il est possible de remplacer, dans une chaîne de réception radar, les deux convertisseurs analogiques-numériques qui fonctionnent en bande vidéo aux sorties du démodulateur en quadrature, par un seul convertisseur analogique-numérique qui fonctionne en fréquence intermédiaire et qui est placé en entrée du démodulateur en quadrature lui-meme réalisé sous forme numérique. Dans ce cas, on s'affranchit des imperfections qui provenaient de la réalisation en analogique du démodulateur en quadrature mais il reste toujours, dans les spectres des composantes en phase et en quadrature du signal vidéo disponibles en sortie du démodulateur, des raies continues parasites dues au décalage du zéro du convertisseur analogique-numérique.

Comme dans le cas précédent, on peut supprimer ces raies continues parasites en détectant leurs amplitudes par moyennage du bruit radar sur les sorties en phase et en quadrature du démodulateur en quadrature pendant un silence radar, et en les retranchant des signaux de sortie en phase et en quadrature du démodulateur. Mais on retrouve les mêmes inconvénients que précédemment à savoir, la nécessité de circuits numériques de structure complexe pour effectuer des moyennes sur le bruit radar et l'obligation d'avoir des périodes de silence radar pour effectuer les mesures. US-A-4907165, FR-A-2396463, EP-A-0483846 et JP-A-10016024 décrivent des circuits pour compenser les décalages du zéro dans un convertisseur analogique-numérique.

La présente invention a pour but de lutter contre les inconvénients précités et de permettre la compensation de la tension de décalage du zéro d'un convertisseur analogique-numérique à un moindre coût.

Elle a pour objet un circuit de codage analogique-numérique à compensation automatique de zéro qui fonctionne avec un signal analogique d'entrée présentant des passages par zéro et qui comporte, outre un convertisseur analogique-numérique à entrée de données analogiques et sortie de données numériques convertissant le signal analogique d'entrée en une succession d'échantillons numériques avec un temps de conversion to ;

- un détecteur de passage par zéro opérant sur le signal analogique d'entrée du convertisseur analogique-numérique et délivrant un signal binaire de sortie dont un état est représentatif d'un passage par zéro et l'autre non ;
- un circuit à retard disposé à la suite du détecteur de passage par zéro dont il retarde le signal binaire de sortie du temps de conversion to ;
- un registre numérique avec une entrée de données numériques connectée à la sortie de données numériques du convertisseur analogique-numérique, une entrée de commande de mémorisation connectée à la sortie du circuit à retard et sensible à l'état binaire représentatif d'un passage par zéro, et une sortie de données numériques ; et
- un soustracteur numérique avec une entrée additive de données numériques connectée à la sortie de données numériques du convertisseur analogique-numérique, une entrée soustractive de données connectée à la sortie de données numériques du registre numérique, et une sortie de données numériques constituant celle du circuit de codage analogique-numérique.

D'autres caractéristiques et avantages de l'invention ressortiront de la description d'un mode de réalisation donné à titre d'exemple. Cette description sera faite en regard du dessin dans lequel :

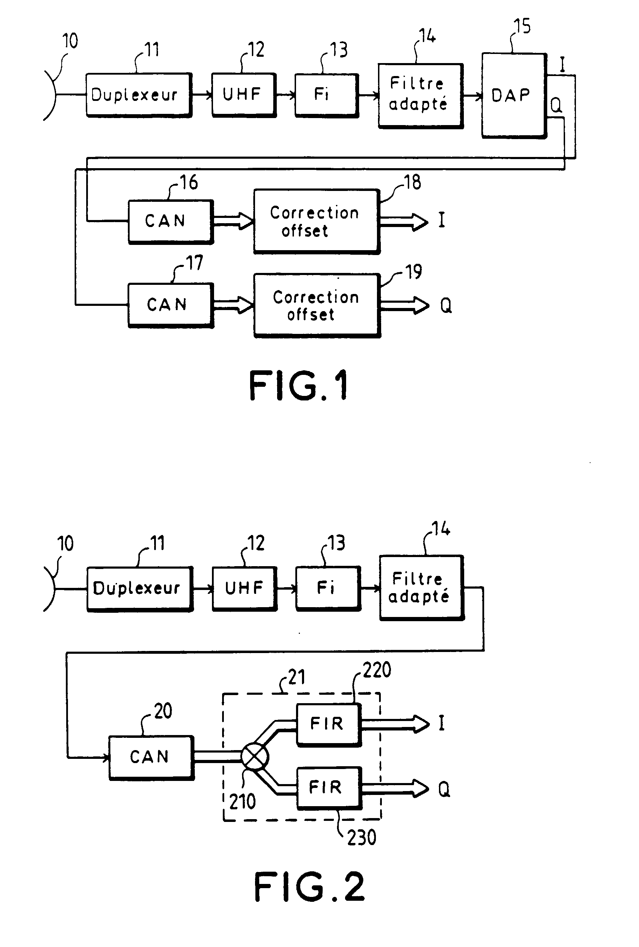

- une figure 1 est un schéma d'une chaîne classique de réception radar mettant en oeuvre des convertisseurs analogiques-numériques en bande vidéo ;

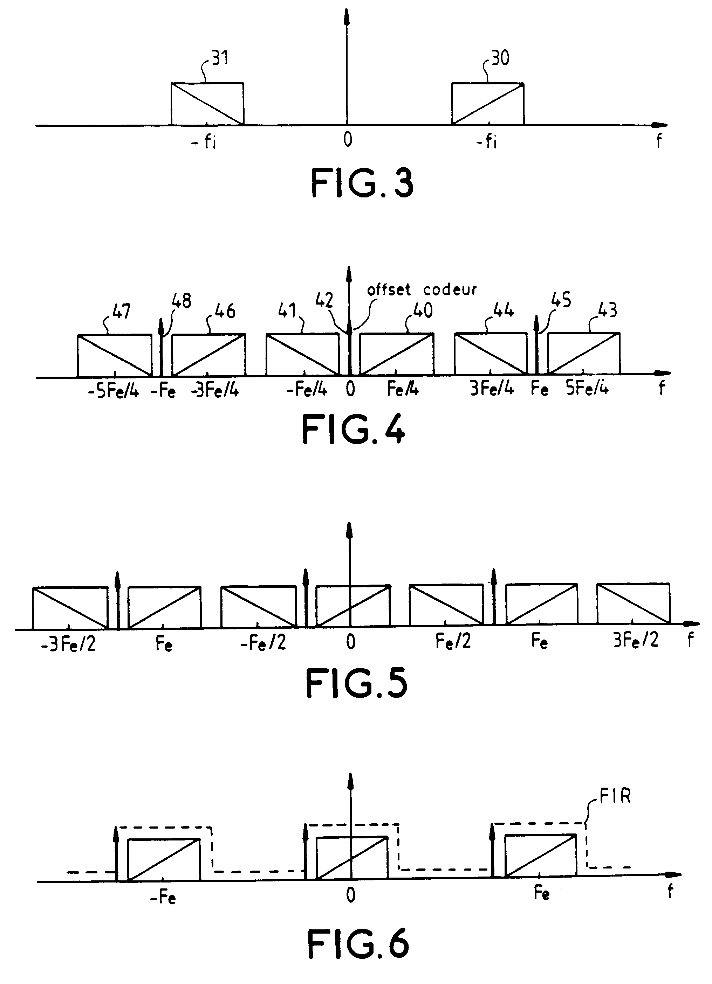

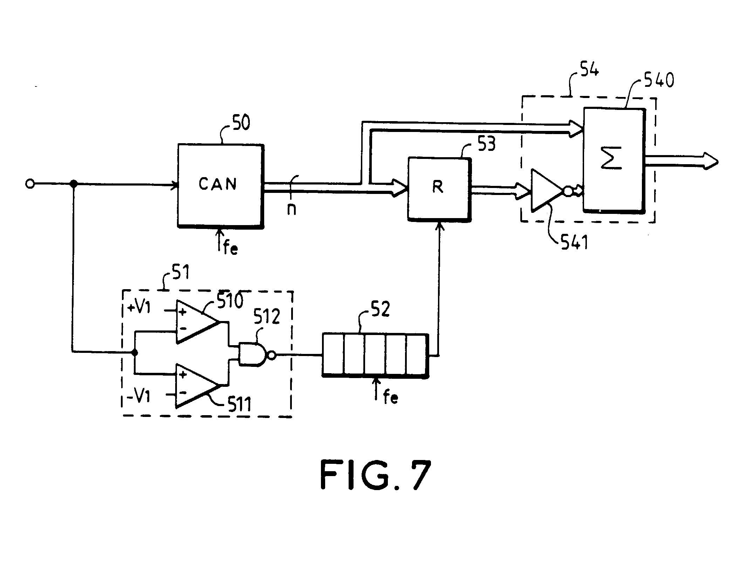

- une figure 2 est un schéma d'une chaîne plus moderne de réception radar mettant en oeuvre un convertisseur analogique-numérique en bande de fréquence intermédiaire ;
- des figures 3, 4, 5 et 6 sont des diagrammes illustrant les spectres de fréquence des signaux disponibles en divers points de la chaîne de réception radar représentée à la figure 2 ; et
- une figure 7 représente un schéma d'un circuit de codage analogique-numérique à compensation automatique du décalage du zéro conforme à l'invention.

La chaîne de réception radar représentée à la figure 1 est couplée avec une chaîne d'émission radar non représentée à une antenne de radar 10 par l'intermédiaire d'un duplexeur 11. Elle débute par un étage hyperfréquence 12 constitué essentiellement d'un amplificateur à faible bruit. Cet étage hyperfréquence 12 est suivi d'un étage à fréquence intermédiaire 13 renfermant un premier démodulateur transférant le signal reçu de la bande des hyperfréquences à une bande haute fréquence de quelques dizaines de mégahertz. L'étage à fréquence intermédiaire 13 mène à un filtre adapté 14 puis à un démodulateur en quadrature 15 dont les sorties vidéo en phase et en quadrature sont connectées aux entrées de deux convertisseurs analogiques-numériques 16, 17 suivis chacun d'un circuit de correction de décalage de zéro 18, 19.

La conversion en numérique du signal reçu par la chaîne de réception radar ne s'effectue ici qu'au niveau du signal vidéo pour réduire au maximum la fréquence de conversion. Cependant, on ne peut éviter que les imperfections de réalisation du démodulateur en quadrature analogique et des convertisseurs analogiques-numériques n'engendrent, dans les composantes en phase et en quadrature numérisées du signal vidéo, des raies continues parasites évoluant en fonction de divers paramètres tels que la température, les tensions d'alimentation, la fréquence de la porteuse d'émission. Pour éliminer ces raies continues parasites on utilise, de manière habituelle, des circuits de corrections de décalage de zéro qui déterminent leurs amplitudes par un moyennage du bruit reçu pendant un silence radar et qui les retranchent des signaux de sortie des convertisseurs analogiques-numériques. Ces circuits de correction de décalage de zéro ont l'inconvénient d'être des circuits numériques de structure relativement complexe et de prix de revient élevé. De plus, l'obligation de prévoir des périodes de silence radar pour leur fonctionnement diminue le temps opérationnel du radar et le rend vulnérable au brouilleur.

La chaîne de réception radar représentée à la figure 2 permet d'éviter les imperfections dues à une réalisation analogique du démodulateur en quadrature en passant en numérique dès la sortie de l'étage à fréquence intermédiaire.

Comme précédemment, cette chaîne de réception radar est couplée avec une chaîne d'émission radar non représentée à une antenne de radar 10 par l'intermédiaire d'un duplexeur 11, et comporte en entrée un étage hyperfréquence 12 suivi d'un étage à fréquence intermédiaire 13 et d'un filtre adapté 14. Mais on trouve en sortie du filtre adapté un convertisseur analogique-numérique 20 qui précède un démodulateur numérique en quadrature 21 formé d'un multiplieur double 210 multipliant les échantillons numériques de sortie du convertisseur analogique-numérique 20 par $\sin 2\pi f_i t$ et $\cos 2\pi f_i t$, $f_i$ étant la fréquence porteuse intermédiaire, et de deux filtres numériques passe-bas à réponse finie 220 et 230 éliminant les battements supérieurs.

Le signal de réception radar Y(t) en sortie du filtre adapté 14 se présente sous la forme d'un signal vidéo S(t) modulant une porteuse à fréquence intermédiaire $f_i$ :

$$Y(t) = S(t) \exp (-j\, 2\pi f_i t)$$

Il a, comme représenté à la figure 3, un spectre de fréquence avec une composante 30 dans une bande centrée sur la fréquence $f_i$ dans le domaine des fréquences positives et une composante image 31 centrée sur la fréquence $-f_i$ dans le domaine des fréquences négatives.

Après être passé par le convertisseur analogique-numérique 20 où il est échantillonné à la fréquence Fe, le signal de réception radar devient :

$$Y(k) \;=\; S(k) \exp\left( -j\, 2\pi\, \frac{f_i}{Fe}\, k \right)$$

Si on choisit :

$$f_i \;=\; Fe\left( n \pm \frac{1}{4} \right)$$

n étant un entier, il vient :

$$Y(k) \;=\; S(k) \exp\left( \pm j\, \frac{\pi}{2}\, k \right)$$

ce qui simplifie le multiplieur 21 qui n'a plus qu'à effectuer des multiplications par $\sin \pm \frac{\pi}{2}$, $\sin \pm \pi$ pour la composante en phase et $\cos \pm \frac{\pi}{2}$, et $\cos \pm \pi$ composante en quadrature.

La figure 4 représente le spectre de fréquence du signal en sortie du convertisseur analogique-numérique dans le cas où on a :

$$f_i = Fe \times \frac{1}{4}$$

On retrouve deux composantes symétriques 40, 41 centrées l'une sur la fréquence Fe/4, l'autre sur la fréquence -Fe/4 avec une raie parasite continue 42 due à la tension de décalage du zéro du convertisseur analogique-numérique et leurs répliques 43, 44, 45 et 46, 47, 48 centrées sur les fréquences Fe et -Fe.

La figure 5 représente le spectre de fréquence des signaux de sortie du multiplieur 21 qui se déduit du spectre de fréquence du signal d'entrée du multiplieur 21 par une translation de Fe/4.

La figure 6 représente le spectre de fréquence du signal de sortie des filtres numériques 220 et 230 qui suppriment les répliques centrées sur les fréquences -Fe/2, Fe/2, 3Fe/2. On constate que la raie parasite due à la tension de décalage du zéro du convertisseur analogique-numérique 20 se retrouve en bout de bande utile, les filtres numériques 220 et 230 n'ayant pas une coupure infiniment raide. Il est donc nécessaire d'éliminer cette raie parasite. Cela peut se faire à l'aide d'un circuit de correction de la tension de décalage du zéro de l'art antérieur placé en sortie du convertisseur analogique-numérique ou, de manière plus avantageuse, en utilisant pour convertisseur analogique-numérique le circuit de codage analogique-numérique à compensation automatique du décalage du zéro représenté à la figure 7.

Ce circuit de codage analogique-numérique comporte :

- un convertisseur analogique-numérique 50 ayant une entrée de données analogiques connectée à l'entrée analogique du circuit de codage et une sortie d'échantillons numériques à n bits parallèles et convertissant un signal analogique d'entrée en une suite d'échantillons numériques avec un temps de conversion to ;
- un circuit de détection de passage par zéro 51 opérant sur le signal analogique d'entrée du convertisseur analogique-numérique 50 et délivrant en sortie un signal binaire dont un état est représentatif d'un passage par zéro et l'autre non ;
- un circuit à retard 52 disposé à la suite du détecteur de passage par zéro 51 dont il retarde le signal binaire de sortie du temps de conversion to ;
- un registre numérique 53 avec une entrée de données numériques connectée à la sortie de données numériques du convertisseur analogique-numérique 50, une entrée de commande de mémorisation connectée à la sortie du circuit à retard 52 et sensible à l'état binaire de ce signal de sortie représentatif d'un passage par zéro, et une sortie de données numériques ; et
- un soustracteur numérique 54 avec une entrée additive de données numériques connectée à la sortie de données numériques du convertisseur analogique-numérique 50, une entrée soustractive de données numériques connectée à la sortie de données numériques du registre numérique 53, et une sortie de données numériques constituant celle du circuit de codage analogique-numérique.

Le détecteur de passage par zéro 51 sert à détecter les instants où le signal analogique d'entrée du convertisseur analogique-numérique 50 prend, en valeur absolue, une amplitude de tension inférieure au quantum correspondant au digit de plus petit poids de la sortie numérique du convertisseur analogique-numérique 50 car, à ces instants, le convertisseur analogique-numérique 50 délivre une valeur numérique correspondant à sa tension de décalage du zéro dite offset dans le langage anglo-saxon. Le circuit à retard 52 permet de tenir compte du temps de conversion to du convertisseur analogique-numérique 50 pour mémoriser dans le registre numérique 53 les valeurs numériques délivrées par le convertisseur analogique-numérique 50 correspondant effectivement à la tension de décalage de zéro de ce dernier. Le soustracteur numérique 54 permet de retrancher systématiquement à tous les échantillons numériques délivrés par le convertisseur analogique-numérique 50 la dernière valeur mesurée de sa tension de décalage du zéro.

Avec le circuit de codage analogique-numérique qui vient d'être décrit il n'est plus nécessaire de prévoir, dans une chaîne de réception radar, de stimuli particuliers tels que les silences radar pour corriger les effets perturbateurs de la tension de décalage du zéro et on évite le recours à des circuits numériques complexes effectuant des moyennages sur le bruit reçu pendant des silences radar.

Le détecteur de passage par zéro 51 peut être réalisé, comme représenté sur la figure 7, à l'aide de deux comparateurs 510, 511 et d'une porte logique de type "non et" 512. Dans le cas d'une logique positive ayant la polarisation positive affectée au niveau logique 1, et d'un registre numérique 53 ayant une commande de mémorisation active au niveau logique 0, le premier comparateur 510 peut avoir son entrée additive portée à une référence positive de tension $+V_1$ inférieure ou égale au quantum correspondant au digit de plus petit poids de la sortie du convertisseur analogique-numérique 50 et son entrée soustractive connectée à l'entrée de données analogiques du convertisseur analogique-numérique 50 tandis que le deuxième comparateur 511 peut avoir son entrée additive connectée à celle de données analogiques du convertisseur analogique-numérique 50 et son entrée soustractive portée à une référence de tension $-V_1$. Les deux comparateurs 510, 511 ont alors leurs sorties qui ne passent simultanément à une tension positive ou au niveau logique 1 que lorsque la tension sur l'entrée de données analogiques du convertisseur analogique-numérique 50 est comprise entre $\pm V_1$ c'est-à-dire inférieure en valeur absolue au quantum de tension correspondant au digit de plus petit poids de ce dernier. Ces deux niveaux logiques 1 appliqués aux entrées de la porte logique de type "non et" 512 entraînent l'apparition, en sortie de cette dernière, d'un niveau logique 0 qui est alors caractéristique des passages par zéro de l'entrée de données analogiques du convertisseur analogique-numérique 50.

Le circuit à retard 52 peut être un registre à décalage cadencé par la fréquence d'échantillonnage $f_e$ du convertisseur analogique-numérique 50. Sur la figure 7 on a supposé qu'il avait cinq étages c'est-à-dire que le temps de conversion to du convertisseur analogique-numérique 50 correspondait à une durée de cinq périodes d'échantillonnage.

Le circuit soustracteur 54 peut être constitué, comme représenté, d'un additionneur numérique 540 à deux entrées dont l'une est précédée d'un inverseur de signe 541.

## Revendications

1. Circuit de codage analogique-numérique à compensation automatique du zéro, fonctionnant avec un signal analogique d'entrée présentant des passages par zéro et comportant un convertisseur analogique-numérique (50), avec une entrée de données analogiques et une sortie de données numériques, convertissant le signal analogique d'entrée en une succession d'échantillons numériques avec un temps de conversion (to), caractérisé en ce qu'il comporte en outre :

   - un détecteur de passage par zéro (51) opérant sur le signal analogique d'entrée du convertisseur analogique-numérique (50) et délivrant un signal binaire de sortie dont un état est représentatif d'un passage par zéro et l'autre non ;
   - un circuit à retard (52) disposé à la suite du détecteur de passage par zéro (51) dont il retarde le signal binaire de sortie du temps de conversion (to);
   - un registre numérique (53) avec une entrée de données numériques connectée à la sortie de données numériques du convertisseur analogique-numérique (50), une entrée de commande de mémorisation connectée à la sortie du circuit à retard (52) et sensible à l'état binaire de ce signal de sortie représentatif d'un passage par zéro, et une sortie de données numériques ; et
   - un soustracteur numérique (54) avec une entrée additive de données numériques connectée à la sortie de données numériques du convertisseur analogique-numérique (50), une entrée soustractive de données numériques connectée à la sortie de données numériques du registre numérique (53), et une sortie de données numériques constituant celle du circuit de codage analogique-numérique.

2. Circuit selon la revendication 1, caractérisé en ce que le détecteur de passage par zéro (51) comporte deux comparateurs (510, 511) l'un, avec un seuil de tension positif, l'autre avec un seuil de tension négatif, lesdits seuils de tension étant inférieurs ou égaux en valeur absolue au quantum de tension correspondant au digit de plus petit poids de la sortie de données numériques du convertisseur analogique-numérique (50), et une porte logique (512) combinant les états de sortie des deux comparateurs (510, 511) de manière à faire correspondre un niveau logique particulier aux passages par zéro de l'entrée de données analogiques du convertisseur analogique-numérique (50).

3. Circuit selon la revendication 1, caractérisé en ce que le circuit à retard (52) est un registre à décalage cadencé par la fréquence d'échantillonnage du convertisseur analogique-numérique (50).

4. Circuit selon la revendication 1, caractérisé en ce que le soustracteur numérique (54) comporte un additionneur numérique (540) à deux entrées dont l'une est précédée d'un inverseur de signe (541).

## Claims

1. Analog-digital coding circuit with automatic compensation for the zero that works with an input analog signal having zero-crossings and that comprises an analog-digital converter (50), with an analog data input and a digital data output, converting the input analog signal into a sequence of digital samples with a conversion time (to), characterized in that it furthermore includes:

   - a zero-crossing detector (51) operating on the input analog signal of the analog-digital converter (50) and delivering an output binary signal, one state of which represents a zero-crossing while the other state does not;
   - a delay circuit (52) positioned after the zero-crossing detector (51), the output binary signal of which it delays by the conversion time (to);
   - a digital register (53) with a digital data input connected to the digital data output of the analog-digital converter (50), a memorizing control input connected to the output of the delay circuit (52) and sensitive to the binary state of this output signal representing a zero-crossing, and a digital data output; and
   - a digital subtractor (54) with a digital data additive input connected to the digital data output of the analog-digital converter (50), a digital data subtractive input connected to the digital data output of the digital register (53), and a digital data output constituting the output of the analog-digital coding circuit.

2. Circuit according to Claim 1, characterized in that the zero-crossing detector (51) has two comparators (510, 511), one with a positive voltage threshold and the other with a negative voltage threshold, said voltage thresholds being, in absolute value, lower than or equal to the quantum of voltage corresponding to the least significant digit of the digital data output of the analog-digital converter (50), and a logic gate (512) combining the output states of the two comparators (510, 511) so as to make a particular logic level correspond to the zero-crossings of the analog data input of the analog-digital converter (50).

3. Circuit according to Claim 1 characterized in that the delay circuit (52) is a shift register with its rate set by the sampling frequency of the analog-digital converter (50).

4. Circuit according to Claim 1, characterized in that the digital subtractor (54) comprises a digital adder (540) with two inputs, one of which is preceded by a sign inverter (541).

**Patentansprüche**

1. Analog/Digital-Codierungsschaltung mit automatischem Nullpunktabgleich, die mit einem analogen Eingangssignal betrieben wird, das Nulldurchgänge aufweist, und einen Analog/Digital-Umsetzer (50) mit einem Eingang für analoge Daten und einem Ausgang für digitale Daten enthält, der das analoge Eingangssignal in eine Folge von digitalen Abtastwerten mit einer Umsetzungszeit (to) umsetzt,

dadurch gekennzeichnet, daß sie außerdem enthält:

- einen Nulldurchgangs-Detektor (51), der das analoge Eingangssignal des Analog/Digital-Umsetzers (50) verarbeitet und ein binäres Ausgangssignal ausgibt, wovon ein Zustand einen Nulldurchgang und der andere keinen Nulldurchgang repräsentiert;
- eine Verzögerungsschaltung (52), die hinter dem Nulldurchgangs-Detektor (51) angeordnet ist, dessen binäres Ausgangssignal sie um die Umsetzungszeit (to) verzögert;
- ein digitales Register (53) mit einem Eingang für digitale Daten, der an den Ausgang für digitale Daten des Analog/Digital-Umsetzers (50) angeschlossen ist, einem Speicher-Steuereingang, der an den Ausgang der Verzögerungsschaltung (52) angeschlossen ist und auf den binären Zustand dieses Ausgangssignals anspricht, das einen Nulldurchgang repräsentiert, sowie einem Ausgang für digitale Daten; und
- einen digitalen Subtrahierer (54) mit einem additiven Eingang für digitale Daten, der an den Ausgang für digitale Daten des Analog/Digital-Umsetzers (50) angeschlossen ist, einem subtraktiven Eingang für digitale Daten, der an den Ausgang für digitale Daten des digitalen Registers (53) angeschlossen ist, und einem Ausgang für digitale Daten, der denjenigen der Analog/Digital-Codierungsschaltung bildet.

2. Schaltung nach Anspruch 1, dadurch gekennzeichnet, daß der Nulldurchgangs-Detektor (51) zwei Komparatoren (510, 511), einer mit einen positiven Spannungsschwellenwert, der andere mit einem negativen Spannungsschwellenwert, wobei die Absolutwerte der Spannungsschwellenwerte kleiner oder gleich dem Spannungsanteil sind, der der niedrigstwertigen Stelle des Ausgangs für digitale Daten des Analog/Digital-Umsetzers (50) entspricht, sowie ein Logikgatter (512) enthält, das die Ausgangszustände der beiden Komparatoren (510, 511) in der Weise kombiniert, daß den Nulldurchgängen des Eingangs für analoge Daten des Analog/Digital-Umsetzers (50) ein besonderer Logikpegel entspricht.

3. Schaltung nach Anspruch 1, dadurch gekennzeichnet, daß die Verzögerungsschaltung (52) ein Schieberegister ist, das durch die Abtastfrequenz des Analog/Digital-Umsetzers (50) getaktet wird.

4. Schaltung nach Anspruch 1, dadurch gekennzeichnet, daß der digitale Subtrahierer (54) einen digitalen Addierer (540) mit zwei Eingängen enthält, wovon einem ein Vorzeicheninvertierer (541) vorhergeht.

FIG.1

FIG.2

FIG.3

FIG.4

FIG.5

FIG.6

8

FIG. 7